Europäisches Patentamt

(19) European Patent Office

Office européen des brevets

(11) Publication number: **0 297 018**
**A2**

# EUROPEAN PATENT APPLICATION

(12)

(21) Application number: 88500008.3

(22) Date of filing: 03.02.88

(51) Int. Cl.⁴: **H 05 K 13/06**
H 05 K 7/06

(30) Priority: 25.05.87 ES 8701531

(43) Date of publication of application:
28.12.88 Bulletin 88/52

(84) Designated Contracting States:
AT BE CH DE FR GB GR IT LI NL SE

(71) Applicant: CIRCUITGRAPH, S.L.
4, Nunez Morgado Street
E-28036 Madrid (ES)

(72) Inventor: Valenciano Melero, Pedro
27, Marqués de Lozoya
Madrid (ES)

(74) Representative: Alonso Langle, Emilio Juan
c/o UDAPI, S.L. Segre, 18, Bajo
E-28002 Madrid (ES)

(54)

(57) The invention refers to a tip to mount or repair printed circuit board lines, designed as an accessory to the electronic circuit wiring device described in Patented Invention 538.302. This tip includes a means of attachment to this device intended to substitute the latter's classic tip, at the free end of which device the flat tip itself is located whose section is equal to that of a thin band of tin coated copper designed to be the wiring element to obtain or repair circuit lines, fed by a reel attached to the device.

FIG.-I

EP 0 297 018 A2

**Description**

## DEVICE TIP TO MOUNT OR REPLACE PRINTED CIRCUIT BOARD WIRING

### SUBJECT-MATTER OF THE INVENTION

The present invention refers to a tip to mount wiring paths on a board made of electrically insulated material to obtain a printed circuit board equally usable to repair pre-existing printed circuit boards, by replacing possibly damaged circuit peths. The tip is designed as a replaceable accessory for a device such as the one claimed in Patented Invention 538.302, owned by the present applicant.

### BACKGROUND OF THE INVENTION

Patented Invention 538.302 describes a procedure to obtain electronic circuits, as well as a device to implement them, intended mainly for experimental circuits, that is, applicable when, instead mass production of a given type of circuit, the aim is to obtain unique experimental circuits such as those laboratory produced both in industry and practical educational or teaching classes.

Briefly, the procedure described in the above mentioned Patented Invention consists of transferring a specific circuit design from a graphic and practical illustration to an insulated board of cardboard, fiber, plastic, etc., mounting the electronic components designed for the circuit on this insulated board by inserting their pins into the latter, and finally, connecting them using pieces of wire extended between the corresponding pins of the two electronic components to be connected, by winding the wire around the pins.

To make handling of this wiring easier, Patented Invention 538.302 envisaged a device similar to a writing instrument, with a replaceable wire reel at one end, attached to the corresponding body, with the wire running lengthwise through said body, coming out the other end through a "guiding" tip for easy wire hadling in winding operations. This device was also equipped with a wire tension device to permit adequate tautness of same as well as a cutting edge to section the wire after each individual wiring operation.

### DESCRIPTION OF THE INVENTION

Using the basic procedure to obtain electronic circuits explained in Patented Invention 538.302, it is now foreseen that the wiring, instead of the cylindrical copper wire described therein, for which the complementary device was intended, may consist of a thin band of tin coated copper to be mounted on the insulated board, following the circuit paths of a printed circuit board, as far as surface arrangement is concerned, but manually, maintaining the basic concept of application exclusively to experimental and similar circuits, modifying the procedure in the form of connecting the wires to the component pins. Instead of winding the wires around said pins, as per Patented Invention 538.302, the connection is now foreseen to be made by soldering.

The tip now recommended is an accessory to the previously mentioned Patented device, designed to substitute the tip of said device whenever necessary, to change the wiring system at will and consequently permit cylindrical type wiring, as in the previous case, or said tin coated copper band wiring, when a new experimental circuit is desired and when or more damaged circuit lines on any commercial printed circuit board are intended to be repaired.

Thus, more specifically, the tip proposed by this invention is formed by a truncated cone shaped body similar to that of the above-mentioned tip, with the same neck or any other means of attachment to the body of the wiring device, but with the special feature that from the free end of said body, corresponding to its narrower end, protrudes the tip itself, tubular but considerably flattened in shape, coinciding with that of the tin coated copper band used with the device, in order to perfectly guide the band.

With this structure, the wiring device shall be able to function exactly the same was as in Patented Invention 538.302 or its tip shall be replaceable by the one now recommended, in which case the reel at the other end shall carry said tin coated copper band, which shall run lengthwise through the device and emerge through the tip. After each wiring operation using this device, the free end of the tin coated copper band shall be soldered to the chosen pin of one of the components by moving the tip attached to the wiring device appropriately over the insulated board, establishing the circuit line path to be described, with the aid of any accessory in this operation to press on the band, as for example a pencil, screwdriver, etc., immediately soldering the band to the corresponding component pin to which it is to be connected, to finally cut the band in the end.

This same operation may also be performed by connecting the ends of the band to the corresponding pins by winding instead soldering.

When trying to repair a damaged path on a conventional printed circuit board of any kind, the tip of the band protruding from the end of the device shall be soldered to one of the parts of the interrupted path, following it with the instrument beyond the point at which it is interrupted, and followed by again soldering the band at the other end of the interrupted line, to also finally cut the tin coated copper band.

When necessary, after reestablishing the adequate section of tin coated copper band in the right position, a small amount of instant adhesive made of cyanocrilator or a similar base shall be applied between the new line and the board, pressing on these elements with the aid of a small cloth to eliminate excess adhesive. The line shall adhere perfectly within a few seconds, functioning as optimally as a new peth and performing exactly as the original one that has been repaired.

## DESCRIPTION OF DRAWINGS

To complete this description and in order to aid in a better understanding of the invention's features, this report is accompanied by a single sheet of drawings, as an intrinsic part of same, showing the following for purposes of illustration, but not limitation:

Figure 1: Shows a lateral view of a device to make electronic circuits equipped with a tip which is the object of the present invention, in which said tip is marked with a heavy line while the rest of the device is marked with a discontinuous one.

Figure 2: Shows a detailed enlargement and axial view of said tip.

## PREFERRED CARRYING OUT OF THE INVENTION

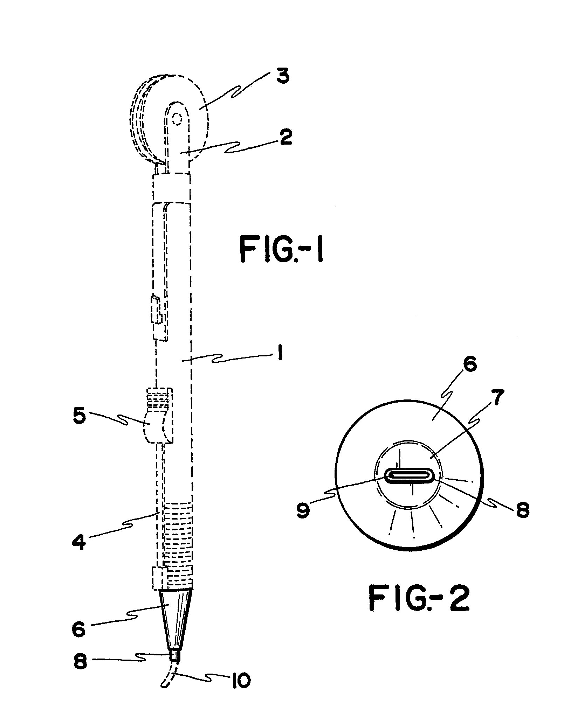

From these figures, and more specifically from figure 1, it is seen how the proposed tip is designed to be a replaceable accessory for a device used to mount experimental electronic circuits such as the one claimed by Patented Invention 538.302, consisting of an elongated body 1, similar to a writing utensile, terminated at one end with a clip 2 to which a replaceable reel 3 is attached, supplying the wire, as well as a cutting edge 4, aided by the corresponding pressing device 5 to cut the wire.

Based on this basic structure for the wiring device, the proposed tip is formed by a body 6, with the same truncated cone shape as the original device's tip 1, equipped with a means of attachment to the end of the latter, opposite the reel end 3, but with the peculiarity that at the narrer free end of this body 6/7, a tubular flattened tip itself may be attached 8, as shown in figure 2, in such a way that the opening 9 of said tip itself, coincides in size with the section of tin coated copper band foreseen as the wiring element, which also in this case shall be supplied by the reel 3 and run lengthwise through the body 1 of the device.

Based on this structure and on the description of the device given in Patented Invention 538.302, when the desired board wiring is to be tin coated copper band or to repair any conventional printed circuit board, the classic copper wire reel shall be substituted by a reel of said tin coated copper band and the tip shall in turn be substituted by the one proposed herein. The device shall be prepared for wiring as well by pressing the free end of the copper band down through body 1 until it comes out the other end throught opening 9 of the tip itself 8, thus rendering the device ready for use.

At this point, if one wishes to repair a conventional printed circuit board, it will suffice to solder the free end of the tin coated copper hand 10, protruding from the tip 6 to one of the two ends of the interruped path on the printed circuit board, then trace the new path moving the point of the instrument over the board exactly repeating the original damaged path, to subsequently go beyond the latter's point of interruption and again proceed to solder the band 10 to the original path and cut the band 10 using the cutting edge 4.

As previously indicated, when necessary, instant adhesive shall be applied between the original line and the new copper band to assure keeping the band on the printed circuit board correctly in place.

On the other hand, when a new experimental circuit is involved, basically the same procedure as that described in Patented Invention 538.302 shall be followed, but now mounting the tin coated copper band sections 10 between the corresponding pins of each pair of electronic components to be connected, either by winding the ends of the bands around the pins, as in the case of said Patent, or by soldering.

In the former case, the initial operational conditions are reestablished on the printed circuit board involved, that is to say, the conditions prior to the repaired damage, and in the second case, a new board is obtained, similar in appearance and functioning to that of a conventional printed circuit board, but obtainable manually, which is extremely important given the specific application of this invention to experimental circuits.

It is not necessary to go any further with this description for any electronics expert to understand the scope of the invention and the advantages that may be obtained.

The materials, shape, size and arrangement of the elements shall be subject to change provided no change in the basic nature of the invention is onvolved.

The terms used in this report are to be interpreted in a broad and non-restrictive sense.

## Claims

1. A tip to mount or repair printed circuit board paths, especially applicable to electronic circuit wiring devices such as the one described in Patented Invention 538.302, either to implement the procedure to obtain such circuits as those described therein or to repair any conventional printed circuit board by establishing a new path over the 'original damaged path of the circuit by soldering the ends of this new path to the original one, at both ends of the point of interruption. This tip is essentially characterized by a truncated cone shaped body, provided with a means of attachment to the body of the wiring device and is an interchangeable accessory with the classic tip for said device. Its special feature is that at the narrower free end of the above mentioned body, provision is made for a tubular flat tip to be attached, coinciding in shape and size with the section of thin tin coated copper band for which it has been designed, in such a way that the tin coated copper band is supplied by a reel situated at the other end of the device. The band runs lengthwise through the device, protruding from the tip to permit tracing the path of a preexisting line, in the case of repairing a damaged path or to lat a new one, in the case of manual wiring of experimental circuits.

2. TIP TO MOUNT OR REPAIR PRINTED CIRCUIT BOARD LINES, as described and claimed in the present 12 page report and illustrated in the attached drawings.

0297018

FIG.-I

FIG.-2